Europäisches Patentamt

European Patent Office

Office européen des brevets

(11) Publication number: **0 272 420**
**A2**

## EUROPEAN PATENT APPLICATION

(21) Application number: **87116339.0**

(51) Int. Cl.⁴: **C23C 18/20**

(22) Date of filing: **05.11.87**

(30) Priority: **22.12.86 US 944728**

(43) Date of publication of application:
**29.06.88 Bulletin 88/26**

(84) Designated Contracting States:
**DE FR GB IT NL**

(71) Applicant: **GENERAL ELECTRIC COMPANY**
**1 River Road**
**Schenectady New York 12305(US)**

(72) Inventor: **Grubb, Willard Thomas**
**2271 Sweetbrier Road**
**Schenectady New York 12309(US)**
Inventor: **Karas, Bradley Ross**
**10 Cumberland Place**
**Scotia New York 12302(US)**
Inventor: **Lewis, Larry Neil**
**7 harvest Drive**
**Scotia New York 12302(US)**
Inventor: **Pickett, James Edward**
**4331 Buckingham Drive**
**Schenectady New York 12304(US)**

(74) Representative: **Catherine, Alain et al**
**General Electric France Service de Propriété**
**Industrielle 18 Rue Horace Vernet B.P. 76**
**F-92134 Issy-les-Mouiineaux Cedex(FR)**

(54) **Photopatterned aromatic polymeric substrates, method for making same and use.**

(57) Patterned electroless plating of aromatic polymeric organic substrate can be achieved by initially irradiating the surface of the plastic with patterned UV energy. The irradiated plastic can then be treated with a colloidal suspension of precious metal, such as palladium or an organo palladium compound. Activation of the applied precious metal provides patterned electroless deposition on the plastic surface when in contact with an electroless plating bath.

EP 0 272 420 A2

# PHOTOPATTERNED AROMATIC POLYMERIC SUBSTRATES, METHOD FOR MAKING SAME AND USE

## BACKGROUND OF THE INVENTION

Plastic substrates have been electrolessly metal plated by activating the surface of the plastic with a precious metal, such as palladium, platinum, gold, silver, iridium, osmium, ruthenium or rhodium, which serves as a nucleating site for electroless metal deposition. A build-up of the thickness of the electrolessly deposited metal, for example copper, can be achieved by electroplating, or by further electroless metal deposition.

Prior to surface activation, the electroless metal plating of plastic substrates often involves cleaning and roughening of the substrate surface followed by surface treatment with an oxidizable multivalent metal ion such as stannous ion. The subsequent immersion of the treated plastic in a precious metal salt solution then effects surface activation.

As taught by Shipley, U.S. Patent No. 3,011,920, incorporated herein by reference, plastic substrates can be sensitized in a one-step process using colloidal precious metal, such as colloidal metallic palladium. The Shipley colloidal precious metal bath also can contain a protective colloid and/or a deflocculating agent to stabilize the colloidal mixture. The protective colloid can be carried onto the plastic surface, and then partially removed by an additional treatment exposing more palladium surface prior to electroless deposition. This "accelerating step" also has been found to deter the formation of blisters in a deposited metal coating on a smooth dielectric surface. Feldstein et al., U.S. Patent No. 3,841,881, also utilizes a colloidal solution of a catalytic metal, such as palladium, along with a quantity of stannous chloride and a quantity of stannic chloride that has been separately aged. According to Feldstein et al., improved results can be achieved with a material such as Teflon® resin having a hydrophobic surface which normally cannot be properly treated utilizing the Shipley technique.

As taught by DeAngelo et al., U.S. Patent No. 3,562,005, incorporated herein by reference, various procedures have been developed to pattern precious metals onto the surface of plastics during the manufacture of circuit boards. A multi-step masking technique requiring a photoresist can be used. The photoresist can be part of an additive or semi-additive process wherein an etching step is used. Patterning of precious metal onto plastic substrates also can be achieved using a selective catalyst placement technique, such as silk screening.

Resistless patterning techniques, that is methods which do not require the use of a photoresist, also are discussed by DeAngelo et al. Resistless patterning can involve pretreatment of the plastic substrate with a reducible or oxidizable metallic salt solution, such as stannous chloride, followed by patterned exposure of the treated substrate through a mask with ultraviolet (UV) light. Normally, immersion of a plastic substrate pretreated with stannous chloride into a solution of precious metal salt can result in activation of the precious metal on the plastic surface. However, due to what is believed to be a redox mechanism, areas of the plastic substrate exposed to irradiation do not activate the precious metal salt. As a result, patterned electroless metal deposition can occur with immersion of the treated plastic into an electroless plating bath.

Sharp, U.S. Patent No. 3,775,121, incorporated herein by reference, is directed to a resistless patterning method involving the pretreatment of a polyimide surface with a metallic species, such as a catalytically active metal like palladium, followed by the poisoning of the catalytically active metal with sulfur or a sulfur-containing compound. Patterned reactivation of the poisoned precious metal can be achieved with UV irradiation or light. Similar resistless patterning techniques, using oxidizable chemicals, such as hydrazine, in place of stannous salts, followed by patterned irradiation also have been found to be effective as shown by Shirk et al., U.S. Patent No. 4,112,129; DeAngelo, U.S. Patent No. 4,096,043; and Beckenbough et al., U.S. Patent No. 4,261,800; all of which are incorporated herein by reference.

The present invention is based on the discovery that photopatterned aromatic polymeric organic substrate, as defined hereinafter, exhibits hydrophilicity in the irradiated areas. An outlineof the mask is clearly shown on the plastic surface after exposure, when it is contacted with water, or water vapor. The photopatterned plastic can be electrolessly metal plated in a resistless manner. Patterned resistless electroless metal deposition can occur after the surface of the photopatterned plastic has been activated with colloidal precious metal, or precious metal in the chemically combined state. In other words, the present invention eliminates the requirement of "surface pretreatment" of the plastic substrate prior to irradiation for the purpose of affecting the photopatterning of subsequently applied metal. The surface of the plastic substrate, therefore, does not have to be treated with multivalent metal ions, hydrazine or poisons, prior to patterned irradiation. Surprisingly, the surface of the neat irradiated plastic can thereafter be treated directly with a commercially available colloidal precious metal mixture, where the palladium is in the zero valent state. Activation of zero valent colloidal precious metal, or precious metal compounds, can be achieved by the use of a conventional accelerator, or in instances where a precious metal compound is used, a reducing agent, which can be in the electroless metal plating bath.

It is not completely understood why the direct exposure of a neat plastic substrate to patterned irradiation under atmospheric conditions, or in an oxygen-containing atmosphere, can influence the patterning of subsequently added precious metal material which can be converted to the catalytically active state. One theory is that patterned physical separation of precious metal values can occur during electroless metal plating from areas which have been photopatterned. Perhaps irradiation weakens the surface of the plastic. Surprisingly, this phenomena has been found only to occur in aromatic polymeric organic substrates as distinguished from aliphatic organic polymeric substrates. Another possible explanation for the absence of electroless metal deposition "where the light shines" is that irradiation oxidizes the surface, and therefore interferes with the reducing action of a subsequently applied reducing agent and/or forms the above-described weakened layer.

An object of the present invention, therefore, is to provide photopatterned aromatic polymeric organic substrates which can be used after surface activation with a precious metal, to make printed circuits and chemically milled parts by electroless metal depostion.

Another object of the present invention is to provide a resistless method of patterning plastic substrates which can be electrolessly plated which does not require the use of unstable chemical solutions, such as aqueous stannous chloride, or carcinogenic materials, such as hydrazine or its derivatives.

A further object of the present invention is to advantageously effect patterned electroless metal deposition onto a neat plastic substrate without using a photoresist while at the same time employing colloidal zero valent precious metal or materials having precious metal in the chemically combined state.

An additional object of the present invention is to provide a method of patterning a variety of precious metals onto a broad variety of plastic substrates to produce a wide spectrum of precious metal patterned plastic substrates useful in the manufacture of a variety of planar or nonplanar complex-shapes.

## STATEMENT OF THE INVENTION

There is provided by the present invention, a resistless method for electrolessly plating at least a portion of aromatic polymeric organic substrate in a patterned manner which comprises the steps of

(1) exposing aromatic polymeric organic substrate surface to patterned electromagnetic irradiation having a wavelength of less than about 400 nm,

(2) treating the resulting surface of the aromatic organic polymeric substrate, including areas irradiated in accordance with step (1), with colloidal precious metal, or precious metal in the chemically combined state, to provide substrate surface having catalytically active precious metal, and

(3) effecting patterned electroless metal plating of the substrate surface of (2), where the surface of the shaped aromatic polymeric organic substrate, prior to step (1), is substantially free of chemically or physically combined hydrazine, hydrazine derivatives, or hydrazine residues, oxidizable or reducible compounds of multivalent metals, or poisons for catalytically active precious metal.

Aromatic organic substrates which can be photopatterned in accordance with the practice of the present invention are preferably in sheet or film form, although complex, curved or irregularly shaped substrates also can be readily photopatterned. The aromatic organic substrate also can be in a form of a laminate or composite having at least one aromatic organic polymeric surface which can be photopatterned, preferably having a thickness of at least about one mil or which can be in combination with another non-aromatic organic polymeric material, such as an aliphatic polymer, or an inorganic material, for example, sheet metal, glass, wood, or ceramic.

Further, the aromatic polymeric organic substrate can be a coating on a substrate, such as paper or wood, or a layered structure, composite or laminate, or the aromatic polymeric organic substrate with an inorganic material, such as ceramic or metal, for example, aluminum or steel. The aromatic polymeric organic substrate can be applied by solution blending, dipping, brushing or spraying. In instances where laminates or layered structures are required, these structures can be made by use of adhesive, hot pressing, coextrusion, or other techniques. Physical blends of aromatic organic polymer also can be utilized with other organic or inorganic materials. For example, aliphatic polymers or inorganic fillers, such as glass fiber or silica, can be blended with aromatic organic polymeric component which can be present in at least 50% by weight.

3

Aromatic organic polymers which can be used to make the afore-described photopatternable aromatic polymeric organic substrates are, for example, polyetherimides, as shown by Heath et al., U.S. Patent No. 3,847,867, Kapton polyimide, PPO® polyphenyleneoxide, polystyrene, polystyrene copolymers, high impact polystyrene, Lexan® polycarbonate, aromatic polysulfones, aromatic polyesters, novolac resins, and blends or alloys of such aromatic organic polymers with each other or other aromatic polymers or blends of such aromatic organic polymers with epoxy resins, nylon, and blendable aliphatic polymers.

Precious metal compounds which can be used as precursors for generating catalytically active precious metals for electroless plating in the practice of the present invention are, for example, bisbenzonitrile palladium dichloride, bisacetonitrile palladium dichloride, bis-triphenylphosphine palladium dichloride, bis-triphenylphosphine dimethyl palladium, bis(triphenylphosphine) di(secondarybutyl) palladium, bis-triphenylphosphine palladium oxalate, bis-triphenylphosphine palladium diamine, tris-triphenylphosphine palladium chloride, tetrakistriphenylphosphine palladium (O), bis-triethylphosphine and bis-tri-n-butylphosphine palladium chloride or the dialkyl e.g., dimethyl, dibutyl, etc., oxalate, and borohydride substituents of the complex, bis-trimethylphosphite palladium dichloride or the dialkyl e.g., dimethyl, disecondary butyl, etc., oxalate, succinate, citrate, and borohydride substitutions, bis-benzonitrile and bis-acetonitrile palladium dichloride, 1,3-butadiene palladium dichloride, and bistriethylene tetramine palladium dichloride and bis-triethylene tetramine palladium oxalate. With respect to alkyl moieties, described above, these are generally from 1 to 6 carbon atoms, preferably from 1 to 4 carbon atoms.

In addition to the above precious metal activator systems, there also can be used colloidal suspensions of precious metals such as taught by Shipley U.S. Patent 3,011,920 and Feldstein et al., U.S. Patent 3,841,881, incorporated herein by reference. For example, typical palladium suspensions which can be used are Shipley Cataposit 44 or Catalyst 9F followed by Shipley Accelerator 19, all manufactured by the Shipley Company of Newton, Massachusetts. Colloidal suspensions of other precious metals such as platinum, gold, silver, iridium, and the like, also can be used.

Electroless metal plating baths which can be used in the practice of the invention are baths of metals such as copper, nickel and cobalt. Typical electroless metal baths are as follows:

## Electroless Copper

| | | | |
|---|---|---|---|
| I. | Copper Sulphate | 10 | gm/l |
| | Sodium Hydroxide | 10 | gm/l |
| | Formaldehyde (37-41% W/V*) | 10 | ml/l |
| | Sodium Potassium Tartrate | 50 | gm/l |
| II. | Cupric Oxide | 30 | gm/l |
| | Sodium Hypophosphite | 10 | gm/l |
| | Ammonium Chloride | 0.1 | gm/l |
| III. | Copper Sulphate | 13.8 | gm/l |
| | Sodium Potassium Tartrate | 69.2 | gm/l |
| | Sodium Hydroxide | 20 | gm/l |
| | Formaldehyde (36% W/V* 12.5% $CH_2OH$) | 40 | ml/l |
| | 2-Mercaptobenzothiazole | 0.003% | |

\* - weight by volume
Bath Temp. Ambient

## Electroless Nickel

| | | | |
|---|---|---|---|
| I. | Nickel Chloride | 80 | gm/l |

| | | | |
|---|---|---|---|
| | Sodium Citrate | 100 | gm/l |
| | Ammonium Chloride | 50 | gm/l |
| | Sodium Hypophosphite | 10 | gm/l |
| | Bath Temp: 180°F ± 20 | | |
| II. | Nickel Chloride Hexahydrate | 20 | gm/l |
| | Ethylene Diamine (98%) | 45 | gm/l |
| | Sodium Hydroxide | 40 | gm/l |
| | Sodium Borohydride | 0.67 | gm/l |
| | Bath Temp: 180°F | | |

Electroless Cobalt

| | | | |
|---|---|---|---|
| I. | Cobalt Chloride Hexahydrate | 30 | gm/l |
| | Sodium Citrate Pentahydrate | 35 | gm/l |
| | Ammonium Chloride | 50 | gm/l |
| | Sodium Hypophosphite, Monohydrate | 20 | gm/l |
| | Bath Temp: 180°F | | |
| II. | Cobalt Sulphate, Heptahydrate | 24 | gm/l |
| | Ammonium Sulphate | 40 | gm/l |
| | Sodium Hypophosphite | 20 | gm/l |
| | Sodium Citrate | 80 | gm/l |
| | Sodium Lauryl Sulphate | 0.1 | gm/l |
| | Bath Temp: 180°F | | |

Typical UV lamps which can be used to irradiate the aromatic organic polymeric substrates are, for example, low or medium pressure mercury vapor discharge lamps which may vary in wattages from about 15 to 450 watts. Radiation at wavelengths below 400 nm and preferably in the range of 180 to 254 nm can be used. Exposing to patterned electromagnetic radiation means that an intensity of at least about 20 milliwatts-seconds per $cm^2$ can be used, and preferably 60 to 180 milliwatt seconds per $cm^2$. Suitable lamps are, for example, GE lamps such as G15T8 germicidal lamps.

In the practice of one form of the method of the present invention, aromatic polymeric organic substrate, hereinafter referred to as "organic substrate" can be initially surface cleaned and surface treated to enhance adhesion of the electroless metal to the organic substrate. Surface cleaning, for example, can include scrubbing or ultrasonicating in a detergent solution.

Other adhesion-enhancing procedures which can be used included grit blasting with a wet slurry of 320 mesh alumina or a chemical treatment involving the immersion in alcoholic one molar potassium hydroxide , for 10 sec. or more with stirring, followed by an alcoholic rinse and drying, or combined treatments.

Radiation of the organic substrate which can be in the form of a sheet or an irregularly shaped injection molded plastic can be effected with UV light in a patterned manner in air or in oxygen-containing atmosphere. Preferably, ambient room air can be used in view of economic and convenience considerations. Exposure time will vary depending upon such factors as distance from the lamp, lamp intensity, etc. It has been found that effective results can be achieved from exposure from about 15 to about 180 minutes. However, an exposure of as little as eight seconds can be effective if a high intensity (300 W/inch) medium pressure Hg lamp is used.

One procedure which can be used to estimate a satisfactory degree of exposure time, particularly with polyimide substrates, is when exposed organic substrate surface is rendered hydrophilic. It also has been found that reduced exposure time can be achieved by uitlizing a substrate temperature in the range of between about 50°C to 200°C, as compared to irradiation under ambient conditions.

The irradiated organic substrate is then treated with a precursor of catalytically active precious metal material in the form of a precious metal compound, as previously defined, or a colloidal mixture of precious metal such as Shipley catalyst solution 9F, or Shipley Cataposit 44 solution. Standard activating procedures can be followed in accordance with the manufacturers' recommendations. For example, the use of Shipley catalyst solution 9F requires from about 1 to 10 minutes, followed by a water rinse for about 3 minutes and thereafter the Shipley Accelerator solution 19 can be used for about 1 to 10 minutes, followed by a water rinse for about 2 to 6 minutes. Alternatively, Shipley Cataprep 404 conditioning solution requires a contact with the irradiated substrate for about one minute followed by a treatment with Shipley Cataposit 44 solution for about 3 minutes, a water rinse for about 3 minutes, and followed by the use of Shipley Accelerator 19 solution for about 3 to 6 minutes and a water rinse thereafter for about 3 to 6 minutes. The electroless plating proceudre can be conducted with the aforementioned electroless plating baths by conventional methods for a period of from 2 to 30 minutes at ambient or elevated temperatures depending upon the choice of bath desired and the thickness desired. In instances where thicknesses of 1 mil or more are required, standard electroplating or special electroless plating procedures can be used with the patterned organic substrate.

One indication of the quality of the patterned electroless deposited metal can be determined by visual inspection for clearness and definition. The degree of adhesion of the metal to the substrate can be shown by a Scotch tape test, where adhesive failure indicates unsatisfactory adhesion. Other aspects of electroless-metal deposit integrity can be measured with an ohm meter, along conductor runs, surface resistance between them, or from an unplated area to a conductor run.

The following examples are given by way of illustration and not by way of limitation. All parts are by weight unless otherwise designated.


## EXAMPLE 1

Polyetherimide made in accordance with the method of Schmidt et al., U.S. Patent 4,443,592, assigned to the same assignee as the present invention and incorporated hereby by reference in the form of a .01 x 2.5 inch film roll is passed on feed and take-up rollers under a low pressure mercury arc lamp, or an array thereof at a distance and at a linear rate such that the residence time underneath the lamp or the array thereof is 30 minutes and the distance below the lamp is 1/2 inch. At a synchronous speed, a UV blocking pattern is fed between the lamp array and the polyetherimide film and in close contact with the polyetherimide film. There is formed a photopatterned film roll having repeating patterns of the opaque portion of the mask as revealed by the hydrophillic surface characteristics of the exposed portions of the film when contacted with water vapor. The photopatterned surface characteristics of the film are found to be substantially unchanged when examined after a period exceeding a year under ambient conditions substantially free of exposure to direct sunlight or fluorescent light.

The photopatterned film is then activated by immersion in Shipley Cataprep 404, Cataposit 44, and Accelerator 19 for 1, 3 and 6 minutes, respectively. An equal time is spent in a water rinse between each active component. The film is then fed into Shipley 328Q electroless copper bath. The time in the Shipley 328Q bath is 7 minutes. An accurate reproduction of the contact mask is continuously found along the surface of the film.


## EXAMPLE 2

A sample of neat polyetherimide Ultem in the form of an injection-molded 1.5 x 6.0 x 1/16 inch sheet was precleaned by ultrasonicating for 1 minute in Micro laboratory detergent solution, manufactured by International Products Corporation, Trenton, New Jersey. The sample was contacted with a magnetic nickel mask with the mask held in close contact by an array of Alnico magnets on the back of the sample. The masked substrate was then exposed to ultraviolet radiation from a low pressure mercury arc tube operating at about 80 watts. The arc tube was 12 inches long and about 0.4 inch in diameter. A 15-minute exposure was effected with the sample about 1/2 inch below the arc tube. After the UV exposure, the sample was dipped into a toluene solution of bis(benzonitrile)palladium dichloride at a concentration of 1.5 grams per liter. Following an immersion time of 10 minutes, the sample was drained onto absorbent paper and then air dried. After this treatment, the sample was plated with electroless copper for about 5 minutes in a commercial electroless copper plating bath, Enplate Cu-402 (Enthone Corporation, West Haven, Connecticut) at room temperature. The Ultem resin sample was found to be plated completely with copper on the back side and a pattern exactly reproducing the pattern of the nickel mask was found on the exposed side.


## EXAMPLE 3

Various 1.5 x 6.0 x 1/6 inch sheets of Lexan polycarbonate, Ultem polyetherimide, PPO polyphenylene oxide, and high impact polystyrene substrates are selected. An equivalent aliphatic resin sample of Nylon-6 is also used. The various substrates are precleaned by ultrasonicating in Micro detergent solution for 1 minute, water rinsed for one minute, and then immersed in alcoholic 1 molar potassium hydroxide solution for 1-2 minutes with stirring followed by an alcohol rinse and dried. Care is taken to avoid undue exposure of the polycarbonate substrate to the KOH methanol treatment.

The various substrates are then photopatterned with a 450 watt medium pressure mercury lamp at a distance of about one inch between lamp and substrate, and utilizing a brass, nickel, or quartz mask. An exposure time of 35 minutes at room temperature is utilized. The irradiated substrates are then activated by immersing in Shipley Cataprep 404, Cataposit 44 and Accelerator 19 for 1, 3 and 6 minutes, respectively. An equal time is spent in a water rinse between each active component. The Shipley 328Q electroless copper bath is used for copper deposition. The time in the Shipley bath is 7 minutes (2 minutes quiescent and 5 minutes magnetically stirred), or 1 minute in quiescent, 328Q and 6 minutes in magnetically stirred Enplate Cu-406 electroless copper bath. With the exception of Nylon-6, an aliphatic polyamide, all of the aromatic organic polymeric resin samples are found to provide substantially equivalent results as obtained with the neat Ultem polyetherimide sample of Example 2 with respect to forming a reproduction of the contact mask after electroless copper deposition. The Nylon-6 sample is found to be substantially the same on the exposed and unexposed sides. The Lexan polycarbonate substrate is thereafter electroplated with copper to a thickness of 1 mil.

EXAMPLE 4

A 3 x 6 x 1/16 inch injection molded sample of Ultem polyetherimide containing 20% by weight of glass fiber was precleaned as in Example 2. One surface of the sample was roughened by grit blasting using an apparatus manufactured by the Pressure Blast Corporation of Manchester, Connecticut. A 320 mesh alumina grit was fed as an aqueous slurry through the gun providing a uniform surface roughness over the area of the sample. The average surface roughness after grit blasting was found to be between 5000 and 7000 Angstroem units as measured by a Sloan Dektak IIA profilometer using a 12.5 micrometer diameter probe. A laser generated wooden mask was laid on the roughened side of the sample. The sample was exposed for 15 hours using 2 (GE 15T8) low pressure mercury arc tubes each operating at 15 watts of electrical input and positioned about 1 inch above the substrate. The arc tubes were commercial germicidal lamps and were mounted about 1.5 inches apart below a semi-parabolic reflector in an ordinary fluorescent lamp fixture. The arc dimensions of each lamp was 15 inches in length by a 1 inch diameter. After UV exposure, the Ultem resin sample was catalyzed by the procedure of Example 2 and plated with electroless copper as in Example 2. Complete copper plating was found on the back side and an electroless metal reproduction of the mask was found on the side exposed to UV irradiation. The copper adhesion was sufficient to pass a Scotch tape test. The surface resistance of the electroless copper layer was from 0.4 to 0.5 ohms per square as measured with a Kiethley Model 530 Surface Resistance Instrument incorporating a Dumas 4 point measuring probe.

EXAMPLE 5

A box of injection molded Ultem resin (neat, unfilled) was cut into a non-planar strip about 1.5 inch in width. This formed a sample in which a flat bottom was connected to nearly vertical sections on either end and the transition to the nearly vertical ends had a radius of curvature of about 0.1 inches. The sample was detergent cleaned as in Example 2. It was then treated with alcoholic potassium hydroxide solution for the purpose of promoting adhesion and improving photopatterning. The alcoholic KOH solution had a concentration of 1 mole per liter. After exposure in the alcholic potassium hydroxide solution, the sample was rinsed and air dried.

The sample was exposed for two hours to ultraviolet radiation, as in Example 4, through a nickel stencil mask consisting of a number of 1/8 inch wide parallel strips separated by 1/16 inch spaces. The mask was formed around the inside of the box section and held in close contact with an array of Alnico magnets that were formed around the outside of the box section. After UV exposure, the sample was catalyzed and electroless plated as in Example 2. The outside section of the box was completely plated with electroless copper and the inside was plated with a pattern which accurately reproduced the pattern of the nickel mask. Adhesion of the copper to the Ultem substrate was sufficient to pass a Scotch tape test.

EXAMPLE 6

A 0.005 x 1.5 x 6 inch sample of Kapton polyimide film was detergent cleaned as in Example 2. It was then exposed through a metal pattern held in contact by a quartz plate to ultraviolet radiation using the ultraviolet lamp of Example 3 for 2 hours. The sample was then catalyzed and plated as in Example 2. The back side of the Kapton polyimide film was completely plated with electroless copper while the front side was copper plated in a pattern which accurately reproduced the pattern of the metal stencil.

EXAMPLE 7

A 1.5 x 6 x 1/16 inch peice of injection molded 30% glass-filled Ultem polyetherimide was wet grit blasted as in Example 4, and detergent cleaned by scrubbing with Micro laboratory detergent. After air drying, the sample was immersed in a stirred solution of potassium hydroxide in methanol for 1 minute, rinsed in methanol, and air dried. The sample was then exposed to the ultraviolet source of Example 2 operating at 40 watts of electrical input, through a nickel mask consisting of 1/8 inch wide stripes with 1/16 inch wide spaces for a time period of 60 minutes. The sample was then catalyzed as follows: 1 minute in Shipley Cataprep 404, 3 minutes in Shipley Cataposit 44, 3-minute water rinse, 3 minutes in Shipley Accelerator 19, and a 3-minute water rinse. Following these steps, it was electroless copper plated for 10 minutes in Enthone Enplate Cu-406 at room temperature. The UV exposed side of the sample had a pattern of electroless copper consisting of 1/8 inch stripes at 1/16 inch wide spacings. This pattern was electroplated in an acid copper sulfate plating bath to a thickness of 0.003 inches. After oven heat treatment at 110°C for 20 hours, a standard peel test was performed. The peel strength was from 6 to 8 lb/in. The resistivity of the copper layer was 2x10 $^3$ ohms/square as measured using a Kiethley Model 530 Surface Resistance Instrument incorporating a Dumas 4 point measuring probe.

EXAMPLE 8

A 1.5 x 3 x 1/8 inch injection molded sample of a block copolymer of polyetherimide and polydimethylsiloxane was exposed to ultraviolet irradiation through a nickel stencil held in contact by an array of Alnico magnets. The exposure was carried out about 1/2 inch below a low-pressure mercury arc tube as in Example 2. The exposure time was 30 minutes. The sample was catalyzed for electroless plating as in Example 7 and then plated with electroless copper in Enthone Enplate Cu-406 for 10 minutes. The sample had a pattern of electroless copper consisting of 0.025 inch lines and spaces, faithfully reproducing the pattern of the nickel mask.

EXAMPLE 9

A sample of commercially available Ultem polyetherimide 1.5 x 6 x 1/16 inch in dimensions was cleaned by ultrasonicating it in Micro laboratory detergent for 1 minute, rinsed and dried. The sample was then irradiated with ultraviolet light through a nickel stencil mask held in place by an array of Alnico magnets. The exposure was carried out 1/2 inch below the ultraviolet source of Example 2 for 15 minutes. This sample was then catalyzed for electroless plating by immersing it in Shipley Catalyst 9F for 3 minutes, water rinsed for 3 minutes, followed by immersion in Shipley Accelerator 19 for 6 minutes, and then water rinsed for 6 minutes. It was then immersed for 5 minutes in Shipley 328Q electroless copper solution. The side of the sample that had been exposed through the nickel mask had a pattern of electroless copper which cleanly reproduced the pattern of the mask.

EXAMPLE 10

A 2 x 3 x 1/16 inch sample of neat Ultem polyetherimide was immersed and agitated for two minutes in 1,1,2-trichlorotrifluoroethane, air dried, immersed and agitated in Shipley 1175A solution at 65°C for five minutes. The sample was then rinsed with water for two minutes, soaked in 2M methanolic KOH for five minutes, water rinsed for two minutes and again air dried.

The sample was then placed on a bed of Alnico magnets on a hot plate at a temperature of 155°C. A nickel mask was then placed on the sample. After a period of about ten minutes, the sample was irradiated in accordance with the procedure of Example 4 using an exposure time of 20 minutes. The sample was then removed and allowed to cool to room temperature.

The sample was then soaked in Shipley Cataprep 404 for one minute, Shipley Cataposit 44 for three minutes, rinsed in water for two minutes, soaked for three minutes in Shipley Accelerator 19, rinsed in water for two minutes and electrolessly plated in Shipley Cuposit 250 bath operating at 47°C.

After electroless copper plating for 20 minutes, the unexposed side of the sample was found to be completely plated while the exposed side of the sample was found to exactly replicate the metal mask pattern.

The same procedure was repeated except that exposure of the substrate to UV irradiation was effected under ambient conditions. It was found that a two-hour electroless copper plating period was required to produce equivalent results.

Although the above examples are directed to only a few of the very many variations which can be utilized in the practice of the present invention, it should be understood that the method of the present invention is directed to the use of a much broader variety of aromatic organic substrates, a much broader variety of precious metal activators, electroless plating baths, and other conditions as set forth in the description preceding these examples.

## Claims

1. Photopatterned organic substrate comprising aromatic organic polymer whose surface is substantially free of chemically or physically combined hydrazine, hydrazine derivatives, or hydrazine residues, oxidizable or reducible compounds of multivalent metals, or poisons for catalytically active precious metal.

2. Photopatterned polyetherimide in accordance with claim 1.

3. Photopatterned shaped polyetherimide exhibiting a patterned hydrophilic surface in accordance with claim 1.

4. Photopatterned film in accordance with claim 1.

5. A photopatterned layered structure in accordance with claim 1.

6. A photopatterned layered structure in accordance with claim 5, comprising aromatic organic polymer and an inorganic substrate.

7. A laminate in accordance with claim 6, where the inorganic substrate is glass.

8. A layered sturcture in accordance with substrate claim 6, where the inorganic substrate is ceramic.

9. A layered structure in accordance with claim 6, where the inorganic substrate is metal.

10. A photopatterned aromatic organic polymeric coating having a thickness of at least 1 mil on a non-aromatic organic polymeric substrate in accordance with claim 1.

11. A method which comprises, exposing to patterned electromagnetic radiation having a wavelength of less than 400 nm, organic substrate comprising aromatic organic polymer whose surface is substantially free of chemically or physically combined hydrazine, hydrazine derivatives, or hydrazine residues, oxidizable or reducible compounds of multivalent metals, or poisons for catalytically active precious metal, until the exposed surface is rendered at least hydrophilic.

12. A method in accordance with claim 11, where the organic substrate comprises a blend of aromatic organic polymers.

13. A method in accordance with claim 11, where the organic substrate is a polyetherimide.

14. A resistless method for electrolessly plating at least a portion of aromatic polymeric organic substrate in a patterned manner which comprises the steps of
(1) exposing aromatic polymeric organic substrate surface to patterned electromagnetic irradiation having a wavelength of less than about 400 nm,
(2) treating the resulting surface of the aromatic organic polymeric substrate, including areas irradiated in accordance with step (1), with a colloidal suspension of precious metal, or precious metal in the chemically combined state, to provide substrate surface having catalytically active precious metal, and
(3) effecting patterned electroless metal plating of the substrate surface of (2),
where the surface of the shaped aromatic polymeric organic substrate, prior to step (1), is substantially free of chemically or physically combined hydrazine, hydrazine derivatives, or hydrazine residues, oxidizable or reducible compounds of multivalent metals, or poisons for catalytically active precious metal.

15. A method in accordance with claim 14, where the aromatic organic polymeric substrate is a shaped substrate.

16. A method in accordance with claim 14, where the aromatic organic polymeric substrate is a polyimide substrate.

17. A method in accordance with claim 16, where the polyimide substrate is a polyetherimide substrate.

18. A method in accordance with claim 17, where the polyetherimide substrate is reinforced with glass fiber.

19. A method in accordance with claim 14, where the aromatic polymeric organic substrate is a nonplanar shaped aromatic polymeric organic substrate.

20. A method in accordance with claim 14, where the aromatic polymeric organic substrate is treated with a colloidal suspension of palladium.

21. A method in accordance with claim 14, where the aromatic polymeric organic substrate is treated with an organopalladium compound.

22. A method in accordance with claim 14, where the electroless plating bath is an electroless copper plating bath.

23. A method in accordance with claim 14, where the aromatic polymeric organic substrate is pretreated by grit blasting its surface.

24. A method in accordance with claim 14, where the aromatic polymeric organic substrate is surface pretreated with an alcoholic solution of an alkali metal hydroxide.

25. A method in accordance with claim 14, where the electroless plated aromatic polymeric organic substrate is electroplated to a thickness of at least one mil.

26. A method in accordance with claim 14, where the aromatic polymeric organic substrate is maintained at a temperature in the range of from 25°C to 200°C during irradiation.

27. A method in accordance with claim 14, where the aromatic polymeric substrate is a polystyrene substrate.

28. A method in accordance with claim 14, where the aromatic polymeric substrate is a polycarbonate substrate.

29. A method in accordance with claim 14, where the aromatic polymeric substrate is a polyphenylene oxide substrate.

30. A method in accordance with claim 14, where the aromatic polymeric substrate is a silicone-polyimide substrate.

31. A method in accordance with claim 14, where the aromatic polymeric substrate is a blend of aromatic organic polymers.

32. A method in accordance with claim 14, where the aromatic polymeric substrate is a blend of aromatic organic polymer and aliphatic organic polymer.

33. A resistless method for electrolessly plating at least a portion of a shaped aromatic polymeric organic substrate in a patterned manner which comprises the steps of

(1) exposing shaped aromatic polymeric organic substrate surface to patterned electromagnetic irradiation having a wavelength of less than about 400 nm,

(2) treating the resulting shaped aromatic organic polymeric substrate, including surface irradiation in accordance with step (1), with a colloidal suspension of precious metal to provide substrate surface having catalytically active precious metal, and

(3) effecting patterned electroless plating of the substrate surface of (2).

34. A method in accordance with claim 33, where the aromatic organic polymeric substrate is a polyimide substrate.

35. A method in accordance with claim 34, where the polyimide substrate is a polyetherimide substrate.

36. A method in accordance with claim 35, where the polyetherimide substrate is reinforced with glass fiber.

37. A method in accordance with claim 35, where the polyetherimide substrate is reinforced with an inorganic filler.

38. A method in accordance with claim 33, where the shaped aromatic polymeric organic substrate is a nonplanar shaped aromatic polymeric organic substrate.

39. A method in accordance with claim 33, where the shaped aromatic polymeric organic substrate is treated with a colloidal suspension of palladium.

40. A method in accordance with claim 33, where the electroless plating bath is an electroless copper plating bath.

41. A method in accordance with claim 33, where the shaped aromatic polymeric organic substrate is surface pretreated by grit blasting its surface.

42. A method in accordance with claim 33, where the shaped aromatic polymeric organic substrate is surface pretreated with an alcoholic solution of an alkali metal hydroxide.

43. A method in accordance with claim 33, where the electroless plated shaped aromatic polymeric organic substrate is electroplated to a thickness of at least one mil.

44. A method in accordance with claim 33, where the shaped aromatic polymeric organic substrate is maintained at a temperature in the range of from 25°C to 200°C during irradiation.

45. A method in accordance with claim 33, where the shaped aromatic polymeric substrate is a polystyrene substrate.

46. A method in accordance with claim 33, where the shaped aromatic polymeric substrate is a polycarbonate substrate.

47. A method in accordance with claim 33, where the shaped aromatic polymeric substrate is a polyphenylene oxide substrate.

48. A method in accordance with claim 33, where the shaped aromatic polymeric substrate is a silicone-polyimide substrate.

49. A method in accordance with claim 33, where the shaped aromatic polymeric substrate is a blend of aromatic organic polymer with an aliphatic resin.